# EUROPEAN PATENT APPLICATION

(11) **EP 4 661 210 A1**
(43) Date of publication of application: **10.12.2025**
(21) Application number: 23924374.4
(22) Date of filing: 28.12.2023
(51) Int. Cl.: H01Q 1/38, H01Q 1/24, H04M 1/02, H04B 1/401, H04B 1/00

(54) **ELECTRONIC DEVICE COMPRISING ANTENNA**

(30) Priority: 20.02.2023 KR 20230022494; 28.03.2023 KR 20230040808
(71) Applicant: Samsung Electronics Co., Ltd., Suwon-si, Gyeonggi-do 16677 (KR)
(72) Inventor: CHOI, Youngbaek, Suwon-si Gyeonggi-do 16677 (KR)
(74) Representative: HGF
(86) International application number: PCT/KR2023/021956
(87) International publication number: WO 2024/177269

(57) **Abstract**

This electronic device may comprise a processor, a wireless communication circuit configured to provide a signal of a specified frequency band, a switching circuit, a first housing including a first conductive portion, and a second housing which includes a second conductive portion and is rotatable relative to the first housing, and may be configured to control the switching circuit such that the signal is transmitted through the second conductive portion, in an unfolded state where the distance between the first conductive portion and the second conductive portion is a predetermined distance or more. The electronic device may be configured to control, in a folded state where the distance between the first conductive portion and the second conductive portion is less than the predetermined distance, the switching circuit to transmit the signal through each of the second conductive portion and a third conductive portion, and in the folded state, the second conductive portion may be arranged to face at least a portion of the first conductive portion. In the folded state, the third conductive portion may be disposed at a position spaced apart from the second conductive portion by a specified distance or more.

## Description

### [Technical Field]

The following descriptions relate to an electronic device comprising an antenna.

### [Background Art]

An electronic device may transmit a signal through an antenna or receive a signal through the antenna. The electronic device may include a conductive portion positioned at a portion of an edge of a metal housing. The conductive portion may operate as an antenna radiator to transmit and/or receive a signal.

The above-described information may be provided as a related art for the purpose of helping understanding of the present disclosure. No argument or decision is made as to whether any of the above description may be applied as a prior art related to the present disclosure.

### [Disclosure]

### [Technical Solution]

In embodiments, an electronic device is provided. The electronic device may comprise a processor, wireless communication circuitry configured to provide a signal of a designated frequency band, a switching circuit, a first housing including a first conductive portion, and a second housing including a second conductive portion and configured to be rotatable relative to the first housing. The processor may be configured to, in an unfolding state in which a distance between the first conductive portion and the second conductive portion is longer than or equal to a certain distance, control the switching circuit to transmit the signal through the second conductive portion. The processor may be configured to, in a folding state in which the distance between the first conductive portion and the second conductive portion is shorter than the certain distance, control the switching circuit to transmit the signal through each of the second conductive portion and a third conductive portion. The second conductive portion may be disposed to face at least a part of the first conductive portion in the folding state. The third conductive portion may be disposed at a position that is spaced apart from the second conductive portion by a predefined distance or more in the folding state.

In embodiments, an electronic device is provided. The electronic device may comprise wireless communication circuitry configured to provide a signal of a designated frequency band. The electronic device may comprise a first housing including a first conductive portion. The electronic device may comprise a second housing including a second conductive portion and configured to be rotatable relative to the first housing. The wireless communication circuitry may be configured to transmit the signal of the designated frequency band through only the second conductive portion in an unfolding state. The wireless communication circuitry may be configured to, in a folding state, transmit the signal of the designated frequency band through each of the second conductive portion and the third conductive portion. In the folding state, a first display area of the first housing and a second display area of the second housing may face each other. In the unfolding state, the first display area and the second display area may face the same direction. The third conductive portion may be different from a conductive portion adjacent to a first non-conductive portion for the first conductive portion and a conductive portion adjacent to a non-conductive portion for the second conductive portion.

### [Description of the Drawings]

FIG. 1 is a block diagram of an electronic device within a network environment according to an embodiment.
FIG. 2A illustrates an unfolding state of an exemplary electronic device.
FIG. 2B illustrates a folding state of an exemplary electronic device.
FIG. 2C is an exploded view of an exemplary electronic device.
FIG. 3 illustrates an example of conductive portions and non-conductive portions of an electronic device.
FIG. 4 indicates an example of an electronic device in a folding state.
FIGS. 5A to 5B indicate an example of an electronic device including a switching circuit.
FIGS. 6A to 6B indicate an operating principle of an antenna using a switching circuit in a folding state.
FIGS. 7A, 7B, and 7C indicate an example of an electronic device including a switching circuit.
FIGS. 8A to 8B illustrate an example of circuitry to adaptively select an antenna according to a state of an electronic device.
FIG. 9 illustrates an operation flow of an electronic device to adaptively select an antenna according to a state of an electronic device.
FIGS. 10A to 10B indicate performance of an electronic device including a switching circuit.
FIGS. 11A to 11B indicate performance of an electronic device including a switching circuit.

### [Mode for Invention]

Terms used in the present disclosure are used only to describe a specific embodiment, and may not be intended to limit a range of another embodiment. A singular expression may include a plural expression unless the context clearly means otherwise. Terms used herein, including a technical or a scientific term, may have the same meaning as those generally understood by a person with ordinary skill in the art described in the present disclosure. Among the terms used in the present disclosure, terms defined in a general dictionary may be interpreted as identical or similar meaning to the contextual meaning of the relevant technology and are not interpreted as ideal or excessively formal meaning unless explicitly defined in the present disclosure. In some cases, even terms defined in the present disclosure may not be interpreted to exclude embodiments of the present disclosure.

In various embodiments of the present disclosure described below, a hardware approach will be described as an example. However, since the various embodiments of the present disclosure include technology that uses both hardware and software, the various embodiments of the present disclosure do not exclude a software-based approach.

A term (e.g., a communication module, a wireless communication module) referring to a component of an electronic device, a term (a front end module (FEM), a power amplifier module (PAM), a FEM including duplexer (FEMid), a power amplifier module including duplexer (PAMid), a low noise amplifier PAM including duplexer (LPAMid), a radio frequency front end (RFFE), a radio frequency integrated circuit (RFIC)) referring to an RF related module, a term (e.g., an antenna, a radiator, an antenna radiator, an antenna terminal, an antenna element) referring to an antenna, a term (e.g., a PCB, an FPCB, a signal line, a feeding line, an RF block, a data line, an electrical connection, wireless communication circuitry, communication circuitry) referring to circuitry, and the like used in the following description are exemplified for convenience of a description. Therefore, the present disclosure is not limited to terms to be described below, and another term having an equivalent technical meaning may be used. In addition, a term such as '...unit, '...device, '...object', and '...structure', and the like used below may mean at least one shape structure or may mean a unit processing a function.

In addition, in the present disclosure, the term 'greater than' or 'less than' may be used to determine whether a particular condition is satisfied or fulfilled, but this is only a description to express an example and does not exclude description of 'greater than or equal to' or 'less than or equal to'. A condition described as 'greater than or equal to ' may be replaced with 'greater than', a condition described as 'less than or equal to' may be replaced with 'less than', and a condition described as ' greater than or equal to and less than' may be replaced with 'greater than and less than or equal to'. In addition, hereinafter, 'A' to 'B' refers to at least one of elements from A (including A) to B (including B). Hereinafter, 'C' and/or 'D' means including at least one of 'C' or 'D', that is, {'C', 'D', and 'C' and 'D'}.

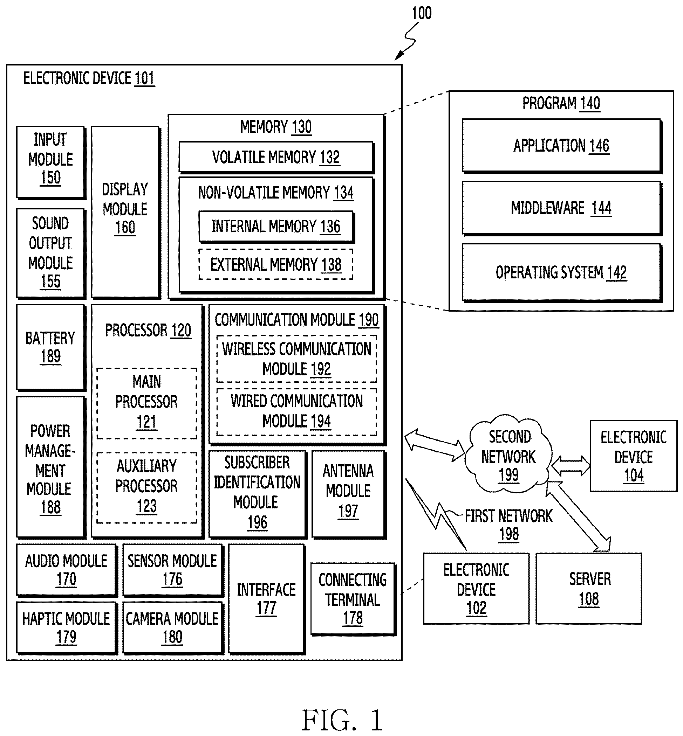

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

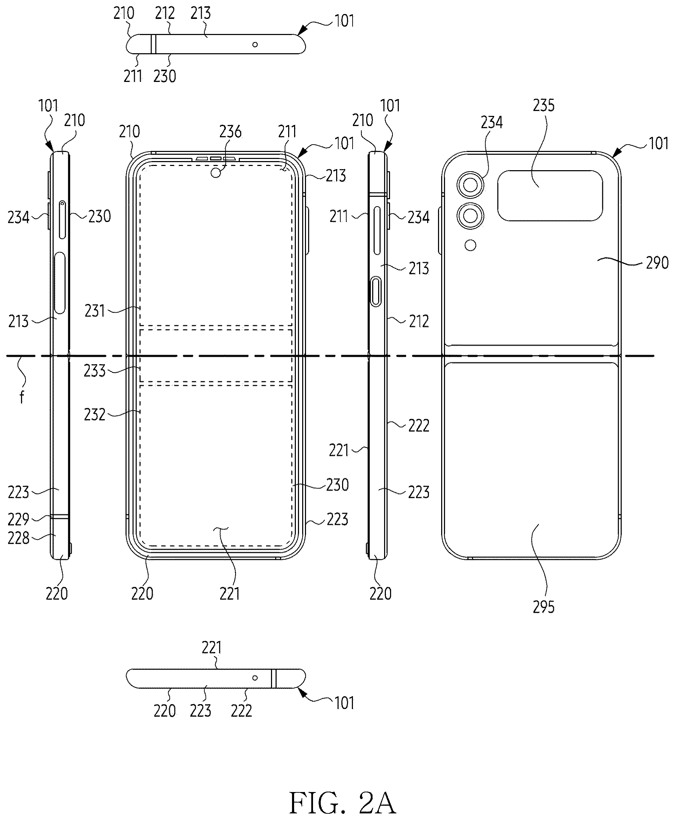

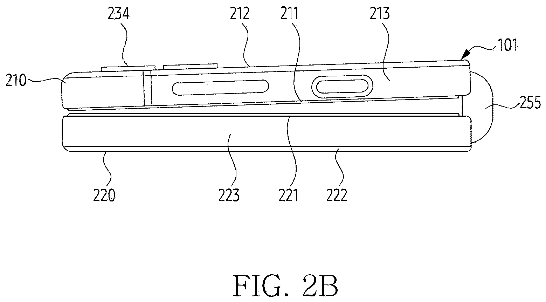

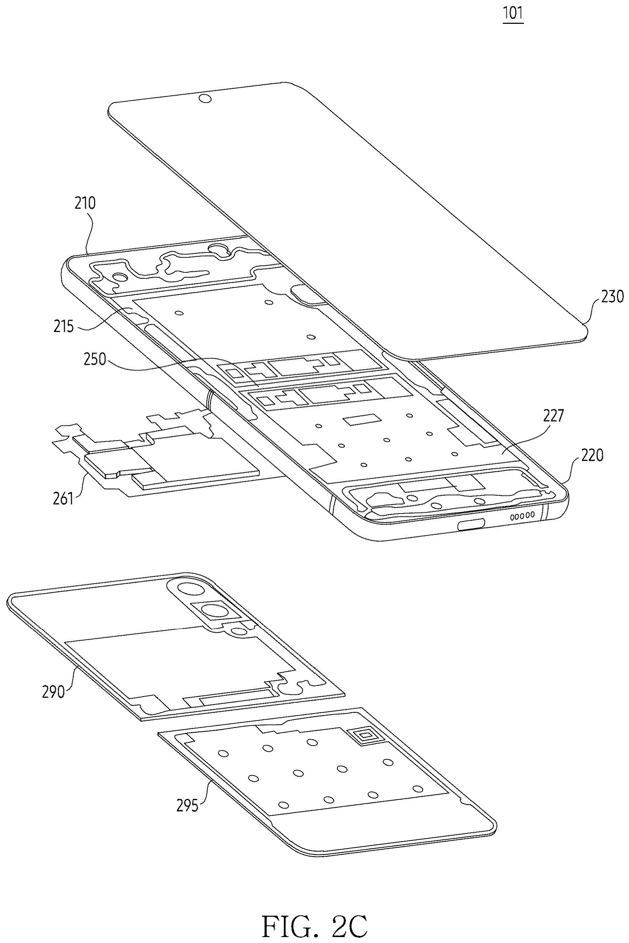

FIG. 2A illustrates an unfolding state of an exemplary electronic device. FIG. 2B illustrates a folding state of an exemplary electronic device. FIG. 2C is an exploded view of an exemplary electronic device.

Referring to FIGS. 2A, 2B, and 2C, according to an embodiment, an electronic device 101 may include a first housing 210, a second housing 220, and a display 230.

According to an embodiment, the first housing 210 may include a first surface 211, a second surface 212 faced away from the first surface 211, and a first lateral surface 213 covering at least a portion of the first surface 211 and the second surface 212. In an embodiment, the first housing 210 may further include at least one camera 234 and a display 235 exposed through a portion of the second surface 212. In an embodiment, the first housing 210 may provide a space formed by the first surface 211, the second surface 212, and the first lateral surface 213 as a space to dispose components of the electronic device 101. In an embodiment, the first lateral surface 213 and a second lateral surface 223 may include a conductive material, a non-conductive material, or a combination thereof. For example, the first lateral surface 213 and the second lateral surface 223 may include a conductive portion 228 and a non-conductive portion 229. The conductive portion 228 may include a plurality of conductive members and the plurality of conductive members may be spaced apart from each other. The non-conductive portion 229 may be disposed between the plurality of conductive members. An antenna structure may be formed by a portion of the plurality of conductive members and a plurality of non-conductive members, or a combination thereof.

In an embodiment, the second housing 220 may include a third surface 221, a fourth surface 222 faced away from the third surface 221, and the second lateral surface 223 covering at least a portion of the third surface 221 and the fourth surface 222. In an embodiment, the second surface 212 may further include a first rear plate 290 disposed on the second surface 212. In an embodiment, the fourth surface 222 may further include a second rear plate 295 disposed on the fourth surface 222.

In an embodiment, a hinge structure 250 disposed on a hinge cover 255 may be disposed between the first lateral surface 213 and the second lateral surface 223. The second lateral surface 223 may be rotatably (or pivotably) connected to the hinge structure 250 with respect to the first lateral surface 213. The hinge structure 250 may include a hinge plate. For example, the hinge plate may include a first hinge plate, and a second hinge plate. The first hinge plate may be connected to the first housing 210, and the second hinge plate may be connected to the second housing 220. In an embodiment, the second housing 220 may provide a space formed by the third surface 221, and the fourth surface 222 faced away from the third surface 221, and the lateral surface 223 covering at least a portion of the third surface 221 and the fourth surface 222 as a space to dispose components of the electronic device 101. In an embodiment, the display 230 may include a window exposed toward an outside. The window may protect a surface of the display 230 and transmit visual information provided from the display 230 to the outside by being formed of a transparent member. For example, the window may include a glass material such as an ultrathin glass (UTG) or a polymer material such as a polyimide (PI). In an embodiment, the display 230 may include a first display area 231 disposed on the first surface 211 of the first housing, a second display area 232 disposed on the third surface 221 of the second housing, and a third display area 233 between the first display area 231 and the second display area 232. At least a portion of the third display area 233 may be disposed on the hinge structure 250.

According to an embodiment, an opening may be formed in a portion of a screen display area of the display 230, or a recess or an opening may be formed in a support member (e.g., a bracket) supporting the display 230. The electronic device 101 may include at least one or more camera aligned with the recess or the opening. For example, the first display area 231 may further include at least one or more camera 236 capable of obtaining an image from the outside through the portion of the first display area 231. According to an embodiment, the electronic device 101 may include the at least one or more camera 236 on a rear surface of the display 230 corresponding to the first display area 231 or the second display area 232 of the display 230. For example, the at least one or more camera 236 may be disposed under the display 230. For example, the at least one or more camera 236 may be covered by the display 230. The at least one or more camera 236 may not be exposed to the outside by being covered by the display 230. However, it is not limited thereto, and the display 230 may include an opening exposing the at least one or more camera 236 to the outside. Although not illustrated in FIGS. 2A and 2B, according to an embodiment, the display 230 may further include a front surface that the display 230 faces and a rear surface opposite to the front surface. In an embodiment, the display 230 may be supported by a first support member 215 of the first housing 210 and a second support member 227 of the second housing 220.

In an embodiment, the hinge structure 250 may be configured to rotatably connect the first support member 215 that is fastened to the first hinge plate and the second support member 227 that is fastened to the second hinge plate. In an embodiment, the hinge cover 255 covering the hinge structure 250 may be at least partially exposed through a space between the first housing 210 and the second housing 220 while the electronic device 101 is in a folding state. In an embodiment, the hinge cover 255 may be covered by the first housing 210 and the second housing 220 while the electronic device 101 is in an unfolding state.

According to an embodiment, the electronic device 101 may be folded with respect to a folding axis (f) passing through the hinge cover 255. For example, the hinge cover 255 may be disposed between the first housing 210 and the second housing 220 of the electronic device 101 so that the electronic device 101 may be bent, curved, or folded. For example, the first housing 210 and/or the second housing 220, based on the hinge structure 250, may rotate with respect to the folding axis (f).

In an embodiment, the electronic device 101 may be folded so that the first housing 210 and the second housing 220 may face each other by rotating with respect to the folding axis (f). In an embodiment, the electronic device 101 may be folded so that the first housing 210 and the second housing 220 are stacked or overlapped with each other.

Referring to FIG. 2C, the electronic device 101 may include the first housing 210, the second housing 220, the hinge structure 250, the display 230, a printed circuit board 261, the display 235, the first rear plate 290, and/or the second rear plate 295. According to an embodiment, the electronic device 101 may omit at least one of the components or may additionally include another component.

According to an embodiment, the hinge structure 250 may include the hinge plate. For example, the hinge structure 250 may include a hinge gear (not illustrated) causing that the first housing 210 and the second housing 220 to be pivotable.

According to an embodiment, the first support member 215 may be partially covered by the first lateral surface 213. For example, the first support member 215 may be integrally formed with the first lateral surface 213. According to an embodiment, the second support member 227 may be partially covered by the second lateral surface 223. For example, the second support member 227 may be integrally formed with the second lateral surface 223. However, it is not limited to thereto. For example, the first support member 215 may be formed separately from the first lateral surface 213. For example, the second support member 227 may be formed separately from the second lateral surface 223.

According to an embodiment, a surface of the first support member 215 may be coupled to the display 230, and another surface of the first support member 215 may be coupled to the first rear plate 290. A surface of the second support member 227 may be coupled to the display 230, and another surface of the second support member 227 may be coupled to the second rear plate 295.

According to an embodiment, the printed circuit board 261 and a battery may be disposed between a surface formed by the first support member 215 and the second support member 227 and a surface formed by the display 235 and the rear plate 290. The first printed circuit board 261 may be electrically connected to the components to implement various functions of the electronic device 101.

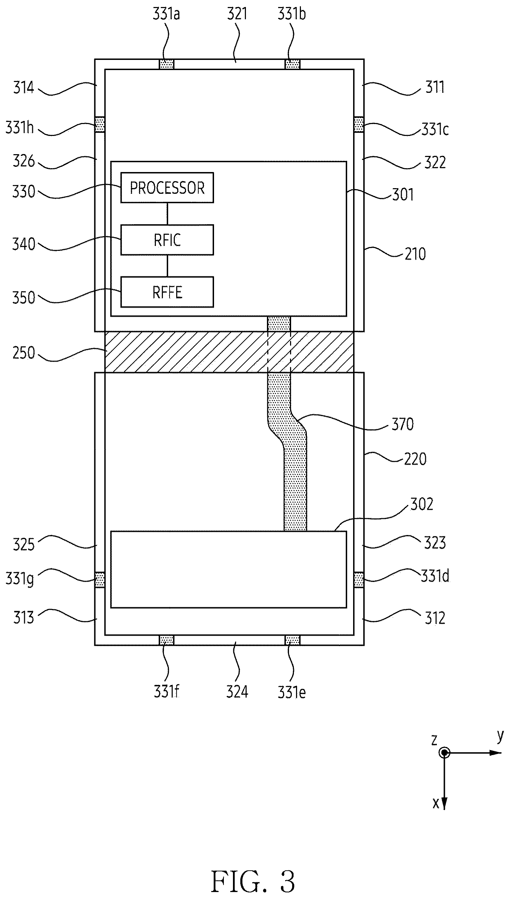

FIG. 3 illustrates an example of conductive portions and non-conductive portions of an electronic device (e.g., the electronic device 101). FIG. 3 illustrates an example of an electronic device in an unfolding state.

Referring to FIG. 3, the electronic device 101 may include a first housing 210, a second housing 220, and a hinge structure 250. The electronic device 101 may be folded so that the first housing 210 and the second housing 220 face each other with respect to a folding axis corresponding to a y-axis on the hinge structure 250.

According to an embodiment, the first housing 210 may include a plurality of conductive portions. For example, the plurality of conductive portions may be disposed along an edge of the first housing 210. For example, the first housing 210 may include a conductive portion 311, a conductive portion 314, a conductive portion 321, a conductive portion 322, and/or a conductive portion 326. In an embodiment, the first housing 210 may include a plurality of non-conductive portions. For example, the first housing 210 may include a non-conductive portion 331a, a non-conductive portion 331b, a non-conductive portion 331c, and/or a non-conductive portion 331h. The non-conductive portion may be formed between the conductive portions. For example, the non-conductive portion 331a may be formed between the conductive portion 321 and the conductive portion 314. The non-conductive portion 331b may be formed between the conductive portion 321 and the conductive portion 311. The non-conductive portion 331c may be formed between the conductive portion 311 and the conductive portion 322. The non-conductive portion 331h may be formed between the conductive portion 326 and the conductive portion 314.

According to an embodiment, the second housing 220 may include a plurality of conductive portions. For example, the plurality of conductive portions may be disposed along the edge of the second housing 220. For example, the second housing 220 may include a conductive portion 323, a conductive portion 312, a conductive portion 324, a conductive portion 313, and/or a conductive portion 325. The second housing 220 may include a plurality of non-conductive portions. For example, the second housing 220 may include a non-conductive portion 331d, a non-conductive portion 331e, a non-conductive portion 331f, and/or a non-conductive portion 331g. The non-conductive portion may be formed between the conductive portions. For example, the non-conductive portion 331d may be formed between the conductive portion 323 and the conductive portion 312. The non-conductive portion 331e may be formed between the conductive portion 312 and the conductive portion 324. The non-conductive portion 331f may be formed between the conductive portion 324 and the conductive portion 313. The non-conductive portion 331g may be formed between the conductive portion 313 and the conductive portion 325.

According to an embodiment, the electronic device 101 may include a processor 330 (e.g., the processor 120). For example, the processor 330 may include one or more processing circuitry. The electronic device 101 may include an RFIC 340 and an RFFE 350 (e.g., the wireless communication module 192). The RFIC 340 and the RFFE 350 may be referred to as wireless communication circuitry or an RF block. According to an embodiment, at least a portion of the conductive portions may operate as an antenna radiator. The processor 330 may provide the at least a portion of the conductive portions with a signal through the RFIC 340 and the RFFE 350 (e.g., the wireless communication module 192). For example, the electronic device 101 may use the conductive portion 312 as a radiator to transmit a signal in a designated frequency band (e.g., an approximately 2.5 GHz band). The conductive portion 312 may be used to radiate the signal. According to an embodiment, the RFIC 340 and the RFFE 350 may be disposed on a first PCB 301 in the first housing 210. For example, the conductive portion 312 may be disposed at the edge of the second housing 220. For example, feeding circuitry and/or impedance matching circuitry for the conductive portion 312 may be disposed on a second PCB 302 in the second housing 220. For an electrical connection between the first PCB 301 and the second PCB 302, a flexible radio frequency cable (FRC) 370 penetrating the hinge structure 250 may be used. The signal may be transmitted to an external electronic device (e.g., the electronic device 102 or the server 108).

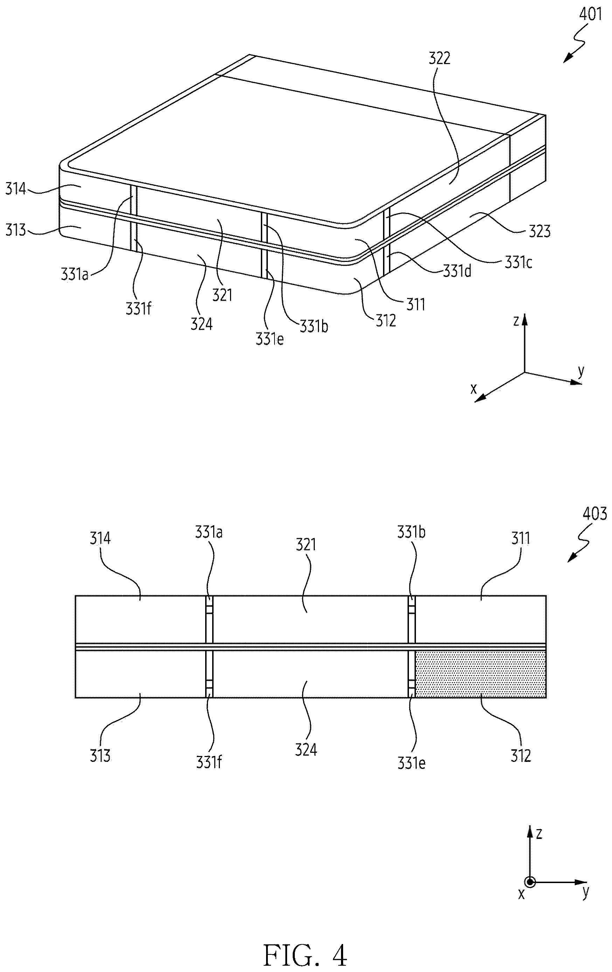

FIG. 4 indicates an example of an electronic device 101 in a folding state. The electronic device 101 illustrates the electronic device 101 of FIG. 3.

Referring to FIG. 4, an example 401 illustrates a perspective view of the electronic device 101 in a folding state. An example 403 indicates a front view of the electronic device 101 in the folding state. The example 403 is a diagram of the electronic device 101 of the example 401 viewed in a (-x) axis direction. Since in an unfolding state of the electronic device 101, conductive portions formed along an edge of a first housing 210 and/or a second housing 220 are relatively less affected by an adjacent structure, antenna performance is higher than the folding state. However, in the folding state of the electronic device 101, a physical characteristic and an electrical characteristic of an antenna radiator may change, by the conductive portions of the first housing 210 and the second housing 220 overlapping. For example, in the folding state of the electronic device 101, a conductive portion 312 may overlap at least a portion of a conductive portion 311.

According to an embodiment, the electronic device 101 may use the conductive portion 312 as a radiator to transmit a signal in a designated frequency band (e.g., an approximately 2.5 GHz band). For example, while making a call through the conductive portion 312, a state of the electronic device 101 may change from the unfolding state to the folding state. In the folding state, at least a portion of the conductive portion 311 may be disposed to face the conductive portion 312. At least a portion of the conductive portion 311 may affect a radiation characteristic of the conductive portion 312. As the state of the electronic device 101 changes from the unfolding state to the folding state, a resonance frequency for the conductive portion 312 may move. According to movement of the resonance frequency, for example, a bandwidth may be narrowed and total efficiency of the antenna may be reduced.

In order to improve the radiation characteristic in the folding state, in embodiments of the present disclosure, a technique to utilize the conductive portion 312 and an additional radiator is described. In order not to degrade quality of the communication even if communication using the conductive portion 312 is being performed, the radiation characteristic may be improved in the folding state through the additional radiator without changing a physical condition (e.g., length, and arrangement) of the conductive portion 312.

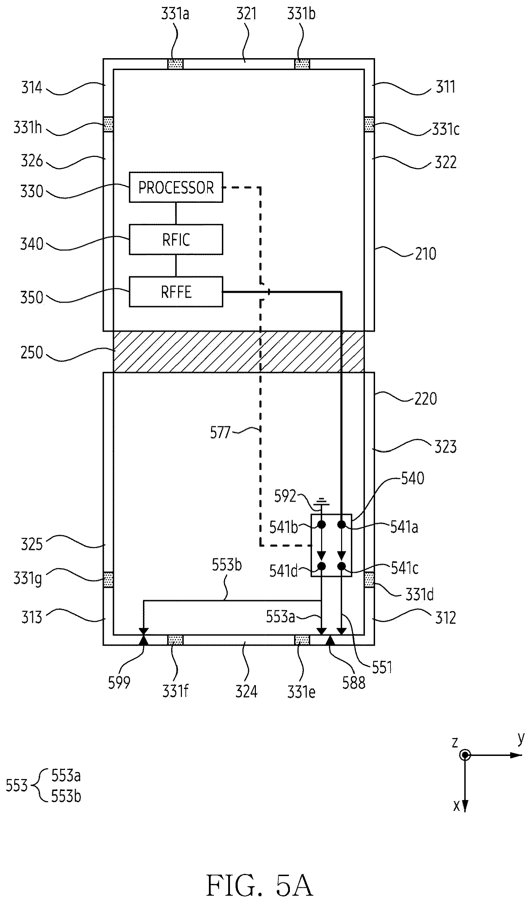

FIGS. 5A to 5B indicate an example of an electronic device (e.g., the electronic device 101) including a switching circuit. The same reference number may be referred to for the same description between drawings. According to an embodiment, in a folding state of an electronic device 101, an additional radiator may be used to improve antenna performance. According to an embodiment, the switching circuit may be used to feed a signal to the additional radiator. According to an embodiment, in the folding state, dual feed may be performed to the radiator used in an unfolding state and the additional radiator. In FIGS. 5A to 5B, an example in which a conductive portion (e.g., the conductive portion 313), disposed in the same housing as a housing (e.g., the second housing 220) in which a conductive portion 312 is disposed, is used as the additional radiator is described.

Referring to FIG. 5A, the electronic device 101 may include a first housing 210, a second housing 220, and a hinge structure 250. The first housing 210 may include a plurality of conductive portions. For example, the first housing 210 may include a conductive portion 311. The first housing 210 may include a plurality of non-conductive portions. For the plurality of conductive portions and the plurality of non-conductive portions of the first housing 210, a description of FIG. 3 may be referred to. The second housing 220 may include a plurality of conductive portions. For example, the second housing 210 may include a conductive portion 312 and a conductive portion 313. The second housing 220 may include a plurality of non-conductive portions. For the plurality of conductive portions and the plurality of non-conductive portions of the second housing 220, the description of FIG. 3 may be referred to.

According to an embodiment, the electronic device 101 may include a processor 330. The electronic device 101 may include an RFIC 340 and an RFFE 350. According to an embodiment, the conductive portion 312 and/or the conductive portion 313 among the conductive portions may operate as an antenna radiator to transmit a signal of a specific frequency band (e.g., approximately 2.5 GHz). For example, in an unfolding state, the conductive portion 312 may operate as an antenna radiator to transmit a signal in the specific frequency band. According to an embodiment, in a folding state, the conductive portion 312 and the conductive portion 313 may operate as an antenna radiator to transmit the signal of the specific frequency band. According to an embodiment, the electronic device 101 may include a switching circuit 540 to control a feeding path based on a change in a state (e.g., the folding state or the unfolding state) of the electronic device 101. According to a state change of the switching circuit 540, the antenna performance in the folding state may be maintained substantially equal to the antenna performance in the unfolding state.

According to an embodiment, the switching circuit 540 may be disposed in an area of the second housing 220. For example, the switching circuit 540 may be disposed on a second PCB 302 of the second housing 220. In an embodiment, in a case that the RFFE 350 feeding a signal for radiation and the processor 330 providing a signal (e.g., a control signal of a path 577) to control the switching circuit are disposed in an area (e.g., the first PCB 301) of the first housing 210, the signals may be provided through a signal line (e.g., FRC) to electrically connect the first PCB 301 and the second PCB 302. However, an arrangement illustrated in FIG. 5A is exemplary, and embodiments of the present disclosure are not limited thereto. According to another embodiment, the switching circuit 540 may also be disposed on the first PCB 301 of the first housing 210.

According to an embodiment, the switching circuit 540 may include a double pole double throw (DPDT) switch. For example, the DPDT switch may include two input ports and output ports. For example, a first input port 541a may be connected to the RFFE 530. The first input port 541a may be connected to one of a first output port 541c and a second output port 541d through the switching circuit 540. For example, a second input port 541b may be connected to ground 592. The second input port 541b may be connected to a port different from a port connected to the first input port 541a among the first output port 541c and the second output port 541d through the switching circuit 540. Hereinafter, the DPDT switch is exemplified as the switching circuit 540, but embodiments of the present invention are not limited thereto. Any switch that supports the same technical function (e.g., adaptively providing dual feed and single feed) may be used as the switching circuit 540.

According to an embodiment, the switching circuit 540 may transmit a signal provided from the RFFE 350 to at least one radiator. In an embodiment, in a first state of the switching circuit 540, the switching circuit 540 may electrically connect the conductive portion 312 and the RFFE 350. As an example, the switching circuit 540 may connect the first input port 541a connected to the RFFE 350 to the first output port 541c connected to a feeding path 551 to the conductive portion 312. For example, the first state may be associated with an unfolding state of the electronic device 101. In an embodiment, in a second state of the switching circuit 540, the switching circuit 540 may electrically connect each of the conductive portion 312 and the conductive portion 313 to the RFFE 350. For example, the second state may be associated with the folding state of the electronic device 101. As an example, the switching circuit 540 may connect the second output port 541d connected to both a feeding branch 553a to the conductive portion 312 and a feeding branch 553b to the conductive portion 312 to the first input port 541a connected to the RFFE 350. The second input port 541b of the switching circuit 540 may be connected to the ground 592.

According to an embodiment, the state (e.g., the first state, the second state) of the switching circuit 540 may be associated with the folding state or the unfolding state of the electronic device 101. For example, the processor 330 may control the state of the switching circuit 540 based on the state of the electronic device 101. The processor 330 may generate a control signal to control the state of the switching circuit 540 based on the state of the electronic device 101. The control signal of the path 577 may indicate the state of the switching circuit 540. For example, the control signal may indicate the state of the switching circuit 540 through a general-purpose input/output (GPIO). For example, the state of the switching circuit 540 may be one of the first state and the second state. According to an embodiment, in a case that the state of the electronic device 101 is in the unfolding state, the processor 330 may transmit the control signal having a first value (e.g., '0' or 'low') to the switching circuit 540. The first value may indicate the first state of the switching circuit 540. Based on the first value, the switching circuit 540 may provide only the conductive portion 312 with the fed signal. For example, in a case that the state of the electronic device 101 is in the folding state, the processor 330 may transmit the control signal having a second value (e.g., '1' or 'high') to the switching circuit 540. The second value may indicate the second state of the switching circuit 540. Based on the second value, the switching circuit 540 may provide each of the conductive portion 312 and the conductive portion 313 with the fed signal. In FIG. 5A, the switching circuit 540 in the unfolding state of the electronic device 101 is illustrated. For example, in the folding state of the electronic device 101, the switching circuit 540 may connect the first input port 541a to the second output port 541d, and connect the second input port 541b to the first output port 541c, unlike an illustration in FIG. 5A.

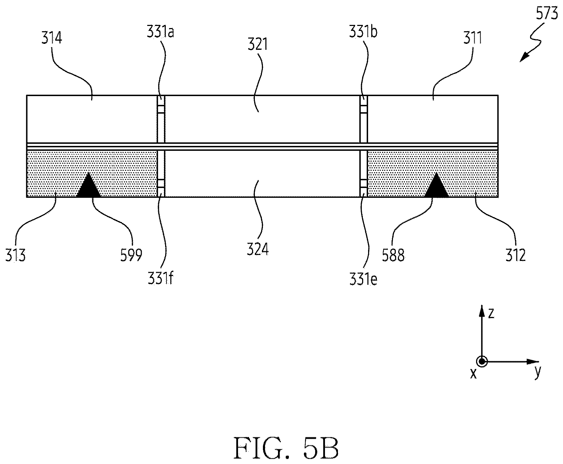

Referring to FIG. 5B, an example 573 illustrates a front view of the electronic device 101 of FIG. 5A in the folding state. In the folding state of the electronic device 101, the conductive portion 312 may overlap at least a portion of the conductive portion 311. For example, the conductive portion 312 may be disposed to face at least a portion of the conductive portion 311 based on the folding axis (e.g., a y-axis).

In an unfolding state, the conductive portion 312 may radiate a signal of a specific frequency band. The state of the electronic device 101 may be changed from the unfolding state to a folding state. In the folding state, the conductive portion 311 may affect a radiation characteristic of the conductive portion 312. According to an embodiment, the electronic device 101 may use an additional radiator to improve the radiation characteristic in the frequency band of the signal of the conductive portion 312 in the folding state. According to an embodiment, the additional radiator may be disposed at a position that is spaced apart from the conductive portion 312. For example, the additional radiator may be disposed at the position that is spaced apart from the conductive portion 312 by a predefined distance or more so as not to affect the radiation characteristic of the conductive portion 312. As an example, the predefined distance may include a length of the non-conductive portion (e.g., the non-conductive portion 331e, the non-conductive portion 331f) and a length of the conductive portion 324. The additional radiator may include a conductive portion not adjacent to the conductive portion 312 among the conductive portions. For example, among the conductive portions, a conductive portion adjacent to the conductive portion 312 may mean the conductive portion 321 or the conductive portion 324. For example, the conductive portion that is not adjacent to the conductive portion 312 may include the conductive portion 313.

According to an embodiment, the additional radiator may include the conductive portion 313. In the folding state of the electronic device 101, a signal may be fed to both the conductive portion 312 and the conductive portion 313. A signal provided through the RFFE 350 and the switching circuit 540 may be fed to a feeding point 588 of the conductive portion 312. The signal provided through the RFFE 350 and the switching circuit 540 may be fed to a feeding point 599 of the conductive portion 313. As the conductive portion 312 and the conductive portion 313 are physically spaced apart by a predefined distance or more, additional radiation using the conductive portion 313 may improve radiation performance of the frequency band in the folding state.

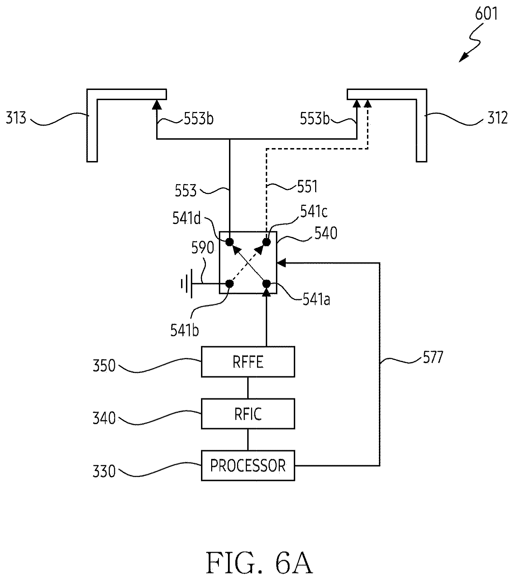

FIGS. 6A to 6B indicate an operating principle of an antenna using a switching circuit in a folding state. The same reference number may be referred to for the same description between drawings.

Referring to FIG. 6A, in a circuitry diagram 601, a processor 330 may provide a switching circuit 540 with a signal of a specific frequency band (e.g., approximately 2.5 GHz) through an RFIC 340 and an RFFE 350. For example, the signal of the RFFE 350 may be transmitted to a first input port 541a of the switching circuit 540. The switching circuit 540 may provide a feeding path 551 with the signal through a first output port 541c or a feeding path 553 with the signal through a second output port 541d according to a state of the switching circuit 540. The feed path 553 may be branched into a feeding branch 553a for a conductive portion 312 and a feeding branch 553b for a conductive portion 313. For example, in a first state of the switching circuit 540, the RFFE 350 may be electrically connected to the conductive portion 312 through the feeding path 551. For example, in a second state of the switching circuit 540, the RFFE 350 may be electrically connected to the conductive portion 312 through the feeding branch 553a and electrically connected to the conductive portion 312 through the feeding branch 553b.

According to an embodiment, the conductive portion 312 may include an '¬'-shaped metal structure having a length L. For example, the metal structure may be a portion of a metal frame of a second housing 220. The metal frame, which is a lateral member forming an outer periphery of the housing 220, may include metal portions (e.g., the conductive portion 312). For example, the conductive portion 312 may include a metal structure with a surface facing an (+) x-axis direction of the electronic device 101 of FIG. 5A, and a feeding point of a feeding path from an (-)x-axis direction to the (+)-axis direction in an inside of the surface. For example, the metal structure may be used as a radiator of a planar inverted F antenna (PIFA). For example, the conductive portion 313 may include an '¬'-shaped metal structure having a length L. For example, the metal structure may be a portion of a metal frame of the second housing 220. For example, the conductive portion 313 may include a metal structure with a surface facing an (+)x-axis direction of the electronic device 101 of FIG. 5A and a feeding point of a feeding path from an (-)x-axis direction to the (+)x-axis direction. The metal structure may be used as a radiator of the PIFA.

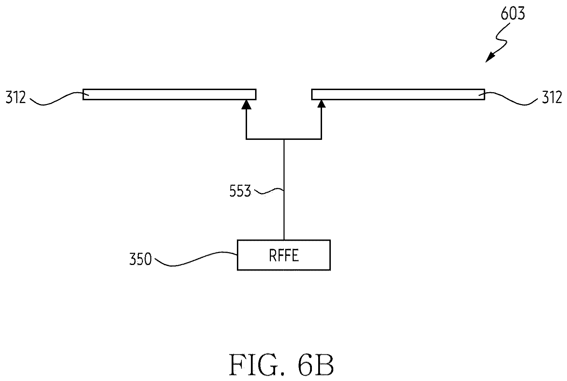

Referring to FIG. 6B, in a circuitry diagram 603, a shape of the metal structure of the conductive portion 312 may be formed of '-'shape, and a shape of the metal structure of the conductive portion 313 may be formed of '- 'shape. When a signal is provided to both the conductive portion 312 and the conductive portion 313, the conductive portion 312 and the conductive portion 313 may be understood as a metal structure of a dipole antenna having a length of 2L. In the folding state of the electronic device 101, since both the conductive portion 312 and the conductive portion 313 are used as a radiator, the conductive portion 312 and the conductive portion 313 may operate as a radiator of a modified dipole antenna having a length of 2L.

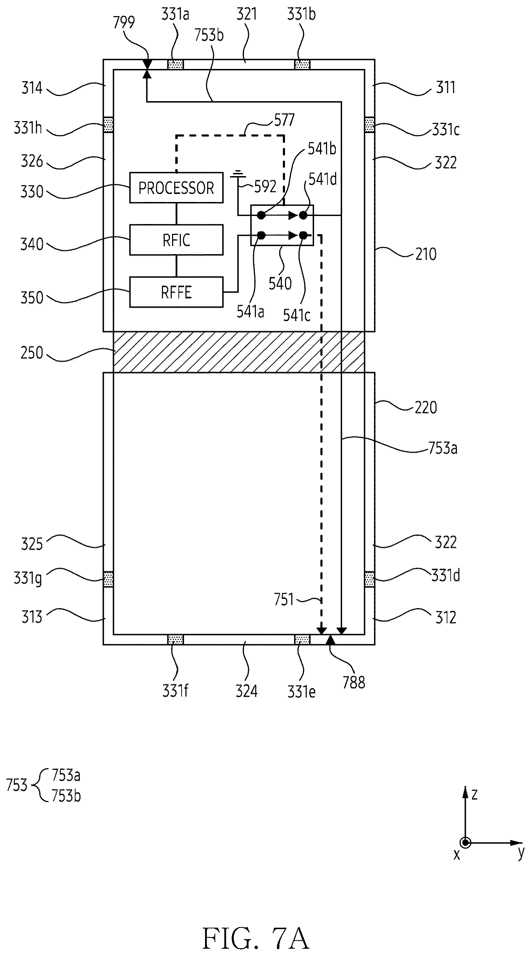

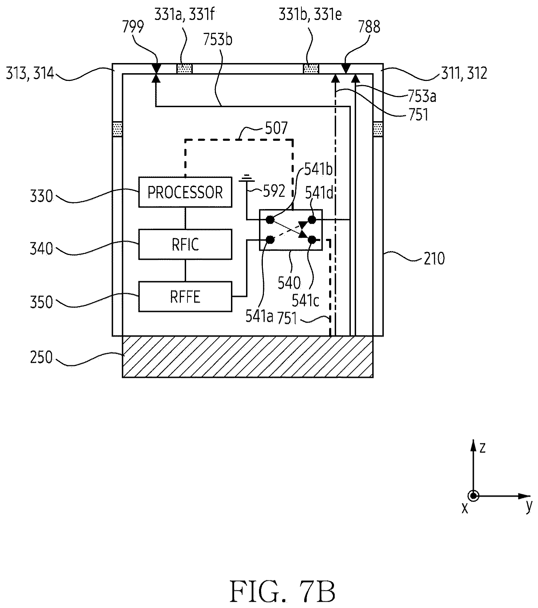

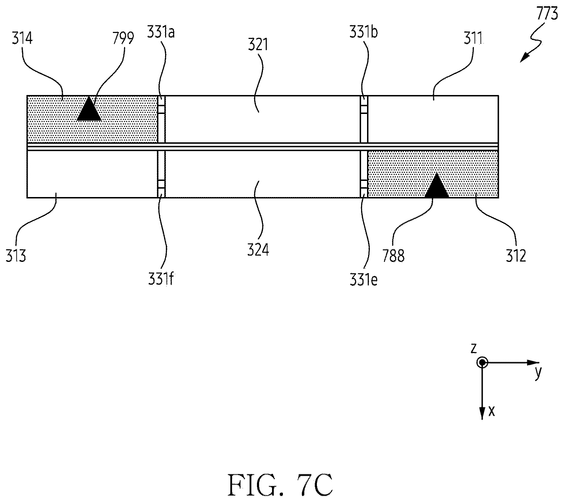

FIGS. 7A, 7B, and 7C indicate an example of an electronic device including a switching circuit. The same reference number may be referred to for the same description between drawings.

According to an embodiment, in a folding state of an electronic device 101, an additional radiator may be used to improve antenna performance. For example, a switching circuit may be used to feed a signal to the additional radiator. In FIG. 7A, FIG. 7B, and FIG. 7C, an example in which a conductive portion (e.g., the conductive portion 314) disposed in a housing (e.g., the first housing 210) different from a housing (e.g., the second housing 220) where a conductive portion 312 is disposed is used as the additional radiator is described.

Referring to FIG. 7A, the electronic device 101 may include a first housing 210, a second housing 220, and a hinge structure 250. The first housing 210 may include a plurality of conductive portions. For example, the first housing 210 may include a conductive portion 311, and a conductive portion 314. The first housing 210 may include a plurality of non-conductive portions. For the plurality of conductive portions and the plurality of non-conductive portions of the first housing 210, a description of FIG. 3 may be referred to. The second housing 220 may include a plurality of conductive portions. For example, the second housing 210 may include the conductive portion 312. The second housing 220 may include a plurality of non-conductive portions. For the plurality of conductive portions and the plurality of non-conductive portions of the second housing 220, the description of FIG. 3 may be referred to.

According to an embodiment, the electronic device 101 may include a processor 330. The electronic device 101 may include an RFIC 340 and an RFFE 350. According to an embodiment, the conductive portion 312 and/or the conductive portion 314 among the conductive portions may operate as an antenna radiator to transmit a signal of a specific frequency band (e.g., approximately 2.5 GHz). For example, in an unfolding state, the conductive portion 312 may operate as an antenna radiator to transmit a signal in the specific frequency band. In the folding state, the conductive portion 312 and the conductive portion 314 may operate as an antenna radiator to transmit a signal of the specific frequency band. The electronic device 101 may include a switching circuit 540 to control a feeding path based on a change in a state (e.g., the folding state or the unfolding state) of the electronic device 101.

According to an embodiment, the switching circuit 540 may be disposed in an area of the first housing 210. For example, the switching circuit 540 may be disposed on a first PCB 301 of the first housing 210. The switching circuit 540 may include, for example, a double pole double throw (DPDT) switch. For example, the DPDT switch may include two input ports and output ports. A first input port 541a may be connected to the RFFE 530. The first input port 541a may be connected to one of a first output port 541c and a second output port 541d. A second input port 541b may be a ground port and may be connected to ground 592.

According to an embodiment, the switching circuit 540 may transmit a signal provided from the RFFE 350 to at least one radiator. For example, in a first state of the switching circuit 540, the switching circuit 540 may electrically connect the conductive portion 312 and the RFFE 350. As an example, the switching circuit 540 may connect the first input port 541a connected to the RFFE 350 to the first output port 541c connected to a feeding path 751 to the conductive portion 312. The first state may be associated with an unfolding state of the electronic device 101. In a second state of the switching circuit 540, the switching circuit 540 may electrically connect each of the conductive portion 312 and the conductive portion 314 to the RFFE 350. The second state may be associated with the folding state of the electronic device 101. As an example, the switching circuit 540 may connect the second output port 541d connected to both a feeding branch 753a to the conductive portion 312 and a feeding branch 753b to the conductive portion 312 to the first input port 541a connected to the RFFE 350. The second input port 541b of the switching circuit 540 may be connected to the ground 592.

The state (e.g., the first state, the second state) of the switching circuit 540 may be associated with the folding state or the unfolding state of the electronic device 101. According to an embodiment, the processor 330 may control the state of the switching circuit 540 based on the state of the electronic device 101. The processor 330 may generate a control signal to control the state of the switching circuit 540 based on the state of the electronic device 101. The control signal may indicate the state of the switching circuit 540. For example, the control signal may be transmitted to the switching circuit 540 through a path 577. The control signal may indicate the state of the switching circuit 540 through a GPIO. The state of the switching circuit 540 may be one of the first state and the second state. According to an embodiment, in a case that the state of the electronic device 101 is in the unfolding state, the processor 330 may transmit the control signal having a first value (e.g., '0' or 'low') to the switching circuit 540. The first value may indicate the first state of the switching circuit 540. Based on the first value, the switching circuit 540 may provide only the conductive portion 312 with the fed signal. In an embodiment, in a case that the state of the electronic device 101 is in the folding state, the processor 330 may transmit the control signal having a second value (e.g., '1' or 'high') to the switching circuit 540. The second value may indicate the second state of the switching circuit 540. Based on the second value, the switching circuit 540 may provide each of the conductive portion 312 and the conductive portion 314 with the fed signal.

Referring to FIG. 7B, the folding state of the electronic device 101 is illustrated. In the folding state of the electronic device 101, the second housing 220 may overlap the first housing 210 by being rotated based on a folding axis (e.g., a y-axis). For example, the conductive portion 311 and the conductive portion 312 may overlap when viewed in an (-)x-axis direction. The conductive portion 313 and the conductive portion 314 may overlap when viewed in the (-)x-axis direction.

According to an embodiment, in the first state of the switching circuit 540, a signal of the RFFE 350 may be provided to the second conductive portion 312. For example, the feeding path 751 may be formed across the first housing 210 and the second housing 220. In the folding state, the feeding path 751 may include a line portion having a direction (e.g., a (-)z-axis direction) to the hinge structure 250 and a line portion having a direction (e.g., a (+)z-axis direction) from the hinge structure 250 to the conductive portion 312.

According to an embodiment, in the second state of the switching circuit 540, a signal of the RFFE 350 may be provided to the second conductive portion 312 and the fourth conductive portion 314. For example, in a case that the fourth conductive portion 314 is formed at an edge of the first housing 210 including the RFFE 350 and the switching circuit 540, the feeding branch 753b may be disposed in the first housing 210. For example, the feed branch 753a may be formed across the first housing 210 and the second housing 220. In the folding state, the feed branch 753a may include a line portion having a direction (e.g., the (-)z-axis direction) to the hinge structure 250 and a line portion having a direction (e.g., the (+)z-axis direction) from the hinge structure 250 to the conductive portion 312. According to an embodiment, the feeding path 751 and the feeding branch 753a may be formed as a signal line (e.g., FRC) to electrically connect the first PCB 301 and a second PCB 302.

Referring to FIG. 7C, an example 773 indicates a front view of the electronic device 101 of FIGS. 7A and 7B in the folding state. The front view is a diagram of the electronic device 101 of FIG. 7B as viewed from the (-)z axis. In the folding state of the electronic device 101, the conductive portion 312 may overlap at least a portion of the conductive portion 311. For example, the conductive portion 312 may be disposed to face at least a portion of the conductive portion 311 based on a folding axis (e.g., the y-axis).

In an unfolding state, the conductive portion 312 may radiate a signal of a frequency band. The state of the electronic device 101 may be changed from the unfolding state to a folding state. In the folding state, the conductive portion 311 may affect a radiation characteristic of the conductive portion 312. According to an embodiment, the electronic device 101 may use an additional radiator to improve the radiation characteristic in the frequency band of the signal of the conductive portion 312 in the folding state. According to an embodiment, the additional radiator may be disposed at a position that is spaced apart from the conductive portion 312. For example, the additional radiator may be disposed at the position that is spaced apart from the conductive portion 312 by a predefined distance or more so as not to affect the radiation characteristic of the conductive portion 312. For example, the additional radiator may include a conductive portion not adjacent to the conductive portion 312 among the conductive portions. For example, among the conductive portions, a conductive portion adjacent to the conductive portion 312 may include a conductive portion 321 or a conductive portion 324. For example, the conductive portion that is not adjacent to the conductive portion 312 may include the conductive portion 314.

According to an embodiment, the additional radiator may include the conductive portion 314. In the folding state of the electronic device 101, a signal may be fed to both the conductive portion 312 and the conductive portion 314. A signal provided through the RFFE 350 and the switching circuit 540 may be fed to a feeding point 788 of the conductive portion 312. The signal provided through the RFFE 350 and the switching circuit 540 may be fed to a feeding point 799 of the conductive portion 314. As the conductive portion 312 and the conductive portion 314 are physically spaced apart by a predefined distance or more, additional radiation using the conductive portion 314 may improve radiation performance of the frequency band in the folding state.

In FIGS. 7A, 7B, and 7C, an example in which the conductive portion 314 is used as the additional radiator for the conductive portion 312 was described. A relationship between the PIFA and the dipole antenna described through FIGS. 6A and 6B may be applied to the conductive portion 314 of FIGS. 7A, 7B, and 7C in the same manner. For example, in the folding state of the electronic device 101, the conductive portion 312 and the conductive portion 314 may operate as the radiator of a modified dipole antenna with a length of 2L.

In FIGS. 5A to 7C, as an additional radiator to be used in the folding state, a radiator (e.g., the conductive portion 313, and the conductive portion 314) that has substantially the same length as a radiator (e.g., the conductive portion 312) used in the unfolding state, or is disposed at a position symmetrical to the radiator was exemplified, but embodiments of the present disclosure are not limited thereto. When the radiator is spaced apart by a predefined distance or more from a radiator used in the unfolding state, the radiator may be used for dual feed in the folding state. For example, when a length of the conductive portion 312 is L, a conductive portion (e.g., the conductive portion 326) having a length M different from L may be used for the dual feed. Aso, for example, a position of the conductive portion (e.g., the conductive portion 325) may not be symmetrical to a position of the conductive portion 312, but the conductive portion 325 may be used for the dual feed.

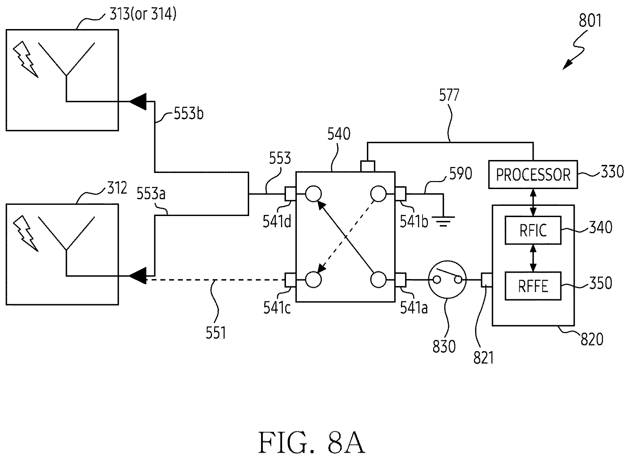

FIG. 8A to 8B illustrate an example of circuitry to adaptively select an antenna according to a state of an electronic device (e.g., the electronic device 101). Hereinafter, operations of circuitry are described based on an example in which an additional radiator (e.g., a conductive portion 313) for a conductive portion 312 is disposed in the same housing (e.g., the second housing 220) as the conductive portion 312, but the operations described below may also be applied in an example in which an additional radiator (e.g., a conductive portion 314) is disposed in another housing (e.g., the first housing 210).

Referring to FIG. 8A, in a circuitry diagram 801, an electronic device 101 may include a processor 330, an RFIC 340, and an RFFE 350. The RFIC 340 and the RFFE 350 may be referred to as wireless communication circuitry 820. The RFFE 350 may output a signal through a feeding port 821. For example, the output of the RFFE 350 may be provided to a switching circuit 540 through a receptacle switch 830.

According to an embodiment, the switching circuit 540 may include four ports. For example, the switching circuit 540 may include a DPDT switch. Two of the four ports may include a first input port 541a and a second input port 541b. The first input port 541a and the second input port 541b may correspond to a pole of the DPDT switch. The first input port 541a may be connected to the RFFE 350 through the receptacle switch 830. The second input port 541b may be connected to ground 592. The second input port 541b may be referred to as a ground port. Other two of the four ports may include, for example, a first output port 541c and a second output port 541d. The first output port 541c and the second output port 541d may correspond to a throw of the DPDT switch. The first input port 541a may be connected to one of the first output port 541c and the second output port 541d through the switching circuit 540. The second input port 541b may be connected to one of the first output port 541c and the second output port 541d. For example, when the first input port 541a is connected to the first output port 541c, the second input port 541b may be connected to the second output port 541d. Also, for example, when the first input port 541a is connected to the second output port 541d, the second input port 541b may be connected to the first output port 541c.

An operation of the switching circuit 540 may be controlled by the processor 330. The processor 330 may provide the switching circuit 540 with a control signal through a path 577. A state of the switching circuit 540 may be changed based on the control signal. The control signal may indicate a state of the switching circuit 540. For example, the processor 330 may control the switching circuit 540 through GPIO communication. As an example, the state of the control signal and the switching circuit 540 according to the GPIO communication may be configured as shown in the following table. The switching circuit 540 may include the DPDT switch.

**[Table 1]**

| Switch GPIO Control Table | | | Mode |
|---|---|---|---|
| GPIO Value | DPDT Switch | | |
| Low | 1-3 | 2-4 | First Mode (open) |
| High | 1-4 | 2-3 | Second Mode (closed) |

Port 1 of the DPDT switch indicates the input port 541a. Port 2 of the DPDT switch indicates the second input port 541b. Port 3 of the DPDT switch indicates the first output port 541c. Port 4 of the DPDT switch indicates the second output port 541d. For example, in a case that a value of the control signal indicates 'low', the DPDT switch may connect the input port 541a and the first output port 541c. The DPDT switch may connect the second input port 541b and the second output port 541d. Also, for example, in a case that the value of the control signal indicates 'high', the DPDT switch may connect the input port 541a and the second output port 541d. The DPDT switch may connect the second input port 541b and the first output port 541c. According to an embodiment, in a case that a state of the electronic device 101 is an unfolding state (e.g., a first mode (open)), the processor 330 may control the switching circuit 540 so that the first output port 541c connected to a conductive portion 312 and the input port 541a are connected. The second input port 541b may be connected to the second output port 541d. Also, according to an embodiment, the processor 330 may control the switching circuit 540 so that the second output port 541d connected to both the conductive portion 312 and a conductive portion 313 and the input port 541a are connected when the state of the electronic device 101 is in a folding state (e.g., a second mode (closed)). The second input port 541b may be connected to the first output port 541c.

According to an embodiment, the first output port 541c may be electrically connected to the conductive portion 312 through a feeding path 551. The second output port 541d may be electrically connected to the conductive portion 312 and the conductive portion 313 through a feeding path 553. The electronic device 101 may include a feeding branch 553a and a feeding branch 553b branched from the feeding path 553. The second output port 541d may be electrically connected to the conductive portion 312 through the feeding branch 553a. The second output port 541d may be electrically connected to the conductive portion 313 through the feeding branch 553b.

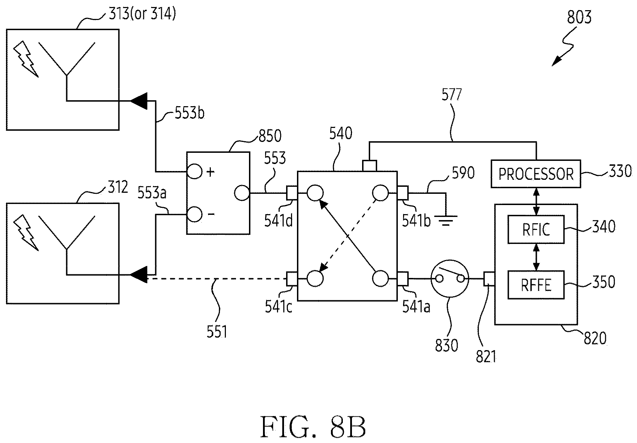

According to an embodiment, an additional circuitry may be used to supply a signal to each of the two conductive portions (e.g., the conductive portion 312 and the conductive portion 313). Referring to FIG. 8B, in a circuitry diagram 803, the electronic device 101 may include balun circuitry 850. The balun circuitry 850 may be configured to perform signal conversion between balanced circuitry and unbalanced circuitry. For example, the balun circuitry 850 may be configured to generate unbalanced output signals based on a balanced input signal and output the unbalanced output signals. The unbalanced output signals may include a positive signal and a negative signal. For example, a first output terminal of the balun circuitry 850 may be configured to provide the negative signal. A second output terminal of the balun circuitry 850 may be configured to provide the positive signal. The second output port 541d may be electrically connected to the conductive portion 312 and the conductive portion 313 through the balun circuitry 850. An input terminal of the balun circuitry 850 may be electrically connected to the second output port 541d through the feeding path 553. The first output terminal of the balun circuitry 850 may be electrically connected to the feeding branch 553a of the conductive portion 312. The second output terminal of the balun circuitry 850 may be electrically connected to the feeding branch 553b of the conductive portion 313.

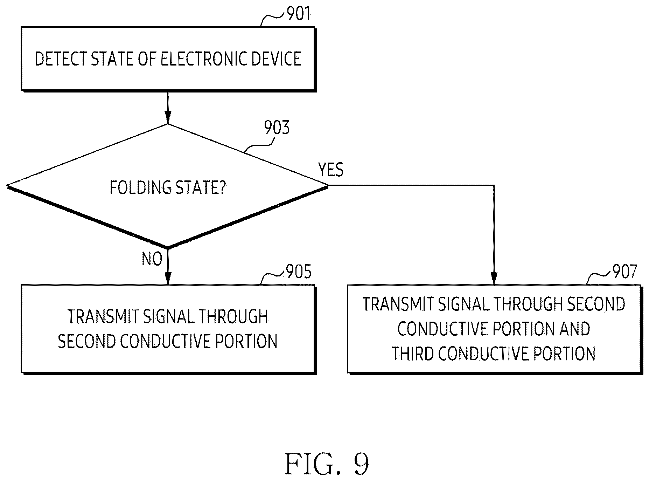

FIG. 9 illustrates an operation flow of an electronic device (the electronic device 101) to adaptively select an antenna according to a state of an electronic device. The antenna may include at least one radiator to transmit a signal of a specific frequency band (e.g., 2.4 GHz). The electronic device 101 may transmit the signal through one radiator or transmit the signal as a dipole antenna through two radiators.

In an operation 901, the electronic device 101 may detect a state of the electronic device 101. The electronic device 101 is a foldable device and may include a first housing 210 and a second housing 220. The first housing 210 and the second housing 220 may rotate based on a folding axis of a hinge structure (e.g., the hinge structure 250).

A state of the electronic device 101 may be a folding state or an unfolding state. For example, in the folding state, a display area of the first housing 210 and a display area of the second housing 220 may face each other. In the unfolding state, a direction of the display area (e.g., a first display area 231) of the first housing 210 and a direction of the second display area (e.g., a second display area 232) of the second housing 220 may face the same direction. Also, for example, in the folding state, the direction in which the display area of the first housing 210 faces may be opposite to the direction in which the display area of the second housing 210 faces. In the unfolding state, the direction in which the display area of the first housing 210 faces may be substantially parallel to the direction in which the display area of the second housing 210 faces. Also, for example, in the folding state, a distance between a first conductive portion (e.g., the conductive portion 311) of the first housing 210 and a second conductive portion (e.g., the conductive portion 312) of the second housing 220 may be shorter than a certain distance. The first conductive portion may be disposed to face at least a portion of the second conductive portion. In the folding state, the first conductive portion may overlap at least a portion of the second conductive portion in a direction in which the display area of the first housing 210 or the second housing 220 is viewed. In the unfolding state, a distance between the first conductive portion (e.g., the conductive portion 311) of the first housing 210 and the second conductive portion (e.g., the conductive portion 312) of the second housing 220 may be longer than or equal to the certain distance.

The electronic device 101 may detect the state of the electronic device 101 through at least one sensor. For example, the at least one sensor may include a hall sensor. For example, the at least one sensor may include a geomagnetic sensor. The electronic device 101 may detect the state of the electronic device 101 based on the hall sensor and/or the geomagnetic sensor.

In an operation 903, the electronic device 101 may identify whether the state of the electronic device 101 is the folding state. The electronic device 101 may identify whether the state of the electronic device 101 detected in the operation 901 is the folding state. For example, the electronic device 101 may identify whether the first conductive portion (e.g., the conductive portion 311) of the first housing 210 and the second conductive portion (e.g., the conductive portion 312) of the second housing 220 are in a certain distance. Also, for example, the electronic device 101 may identify whether the display area of the first housing 210 faces the display area of the second housing 220. In the operation 903, in a case that the state of the electronic device 101 is detected as the unfolding state, the electronic device 101 may perform an operation 905. In a case that the state of the electronic device 101 is detected as the folding state, the electronic device 101 may perform an operation 907.

In the operation 905, the electronic device 101 may transmit a signal of the frequency band through the second conductive portion (e.g., the conductive portion 312). The electronic device 101 may electrically connect a feeding path of a second conductive portion to wireless communication circuitry (e.g., the RFIC 340 and the RFFE 350) through a switching circuit (e.g., the switching circuit 540). In this case, the wireless communication circuitry may not be electrically connected to another conductive portion (e.g., conductive portion of the operation 907). For example, the switching circuit 540 may provide the second conductive portion with a signal fed from the RFFE 350.

In the operation 907, the electronic device 101 may transmit a signal of the frequency band through the second conductive portion (e.g., the conductive portion 312) and a third conductive portion (e.g., the conductive portion 313, the conductive portion 314). The third conductive portion may be disposed to be spaced apart from the second conductive portion in the folding state. According to an embodiment, the third conductive portion may be disposed at a position not adjacent to the second conductive portion in the folding state. For example, two conductive portions being adjacent may indicate that the two conductive portions are adjacent to the same non-conductive portion. That the two conductive portions are spaced apart may indicate that the two conductive portions are not adjacent. For example, the third conductive portion may be different from a conductive portion (e.g., the conductive portion 321) adjacent to a first non-conductive portion (e.g., the non-conductive portion 331b) for the first conductive portion and a conductive portion (e.g., the conductive portion 324) adjacent to a second non-conductive portion (e.g., the non-conductive portion 331e) for the second conductive portion. Also, according to an embodiment, the third conductive portion may be disposed to be spaced apart from the second conductive portion by a predefined distance or more in the folding state. For example, a value of the predefined distance may include a length of a conductive portion (e.g., the conductive portion 324) adjacent to the second conductive portion and a length of a non-conductive portion (e.g., the non-conductive portion 331e) between the conductive portions.

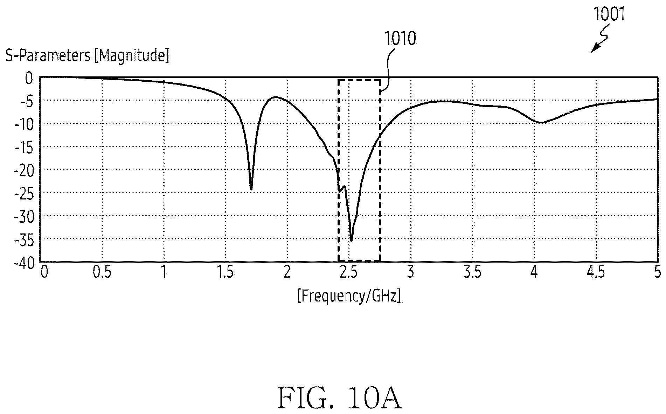

FIGS. 10A to 10B indicate performance of an electronic device (e.g., the electronic device 101) including a switching circuit (e.g., the switching circuit 540).

Referring to FIG. 10A, a graph 1001 indicates radiation performance of the electronic device 101 of FIG. 5A, in which a signal is fed to each of the conductive portion 312 and the conductive portion 313 in a folding state, through the switching circuit 540. The graph 1001 indicates an S-parameter for each frequency. For example, the S-parameter may include a reflection coefficient S₁₁. A horizontal axis of the graph 1001 indicates a frequency (unit: GHz), and a vertical axis of the graph 1001 is a magnitude of the S-parameter, and indicates a reflection coefficient (unit: decibel (dB)). For example, in a frequency range 1010 of greater than or equal to approximately 2.4 GHz and less than approximately 2.7 GHz, all of the reflection coefficient value is less than or equal to -10 dB. As the reflection coefficient is low, the more power may be transmitted to an antenna terminal. Referring to the graph 1001 and the frequency range 1010, since all the reflection coefficient values are 0 based on the '-10 dB', it may be confirmed that various bandwidths are possible in the frequency range 1010. For example, in the folding state of the electronic device 101 of FIG. 5A, the possible bandwidth may be extended than the bandwidth in an unfolding state.

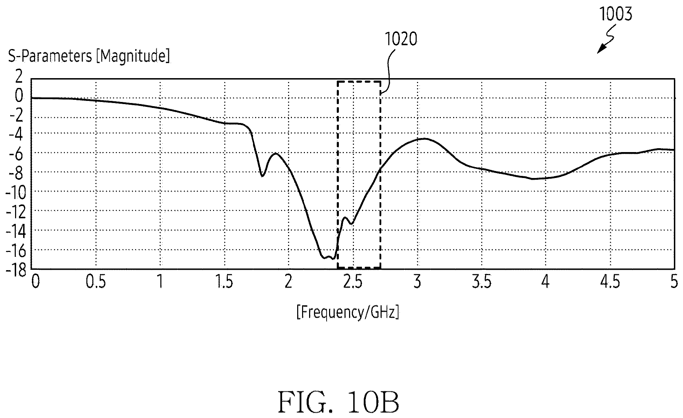

Referring to FIG. 10B, a graph 1003 indicates radiation performance of the electronic device 101 of FIG. 7A, in which a signal is fed to each of the conductive portion 312 and the conductive portion 313 in the folding state, through the switching circuit 540. The graph 1003 indicates an S-parameter for each frequency. For example, the S-parameter may include a reflection coefficient S₁₁. A horizontal axis of the graph 1003 indicates a frequency (unit: GHz), and a vertical axis of the graph 1003 is a magnitude of the S-parameter, and indicates a reflection coefficient (unit: dB). In a frequency range 1020 of greater than or equal to approximately 2.4 GHz and less than approximately 2.7 GHz, the reflection coefficient values in a certain range are less than or equal to -10 dB. Referring to the graph 1003 and the frequency range 1020, it may be confirmed that a bandwidth in the predetermined range is secured based on the '-10 dB'. For example, in the folding state of the electronic device 101 of FIG. 7A, the possible bandwidth may be maintained at a level substantially equivalent to the bandwidth in the unfolding state.

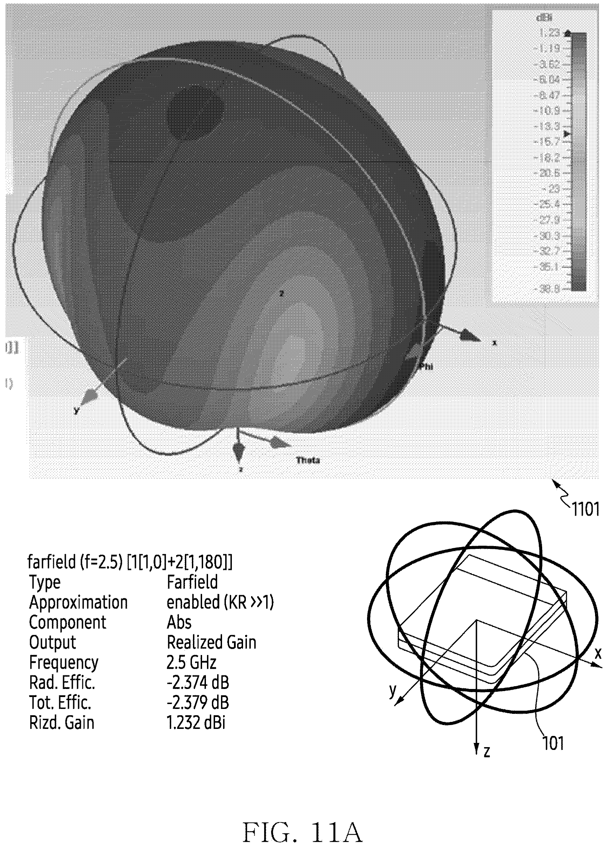

FIGS. 11A to 11B indicate performance of an electronic device (e.g., the electronic device 101 FIG. 5A or the electronic device 101 FIG. 7A) including a switching circuit. In FIGS. 11A to 11B, as performance, radiation efficiency and total antenna efficiency are described.

Referring to FIG. 11A, an example 1101 indicates a radiation pattern of the electronic device 101 of FIG. 5A in which a signal is fed to each of a conductive potion 312 and a conductive potion 313 in a folding state through the switching circuit 540. As shade becomes darker, an antenna gain (unit: decibel isotropic (dBi)) indicates higher. In the example 1101, the radiation efficiency may be approximately -2.374 dB, and total antenna efficiency may be approximately - 2.379 dB. For example, in an unfolding state, the radiation efficiency may be approximately - 2.873 dB, and the total antenna efficiency may be approximately -3.068 dB. In the folding state, it may be confirmed that the total antenna efficiency of the electronic device 101 of FIG. 5A is improved by approximately 0.6 dB compared to the total antenna efficiency in the unfolding state.

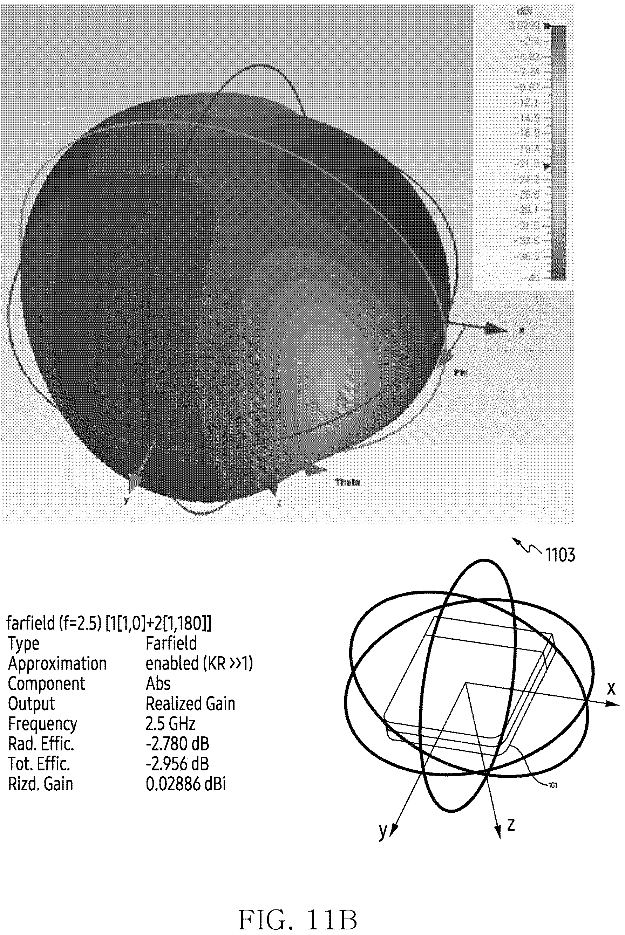

Referring to FIG. 11B, an example 1103 indicates a radiation pattern of the electronic device 101 of FIG. 7A in which a signal is fed to each of the conductive potion 312 and the conductive potion 314 in the folding state through the switching circuit 540. As shade becomes darker, an antenna gain (unit: dBi) indicates higher. In the example 1103, the radiation efficiency may be approximately -2.780 dB, and total antenna efficiency may be approximately -2.956 dB. For example, in the unfolding state, the radiation efficiency may be approximately -2.873 dB, and the total antenna efficiency may be approximately -3.068 dB. In the folding state, it may be confirmed that the total antenna efficiency of the electronic device 101 of FIG. 7A is equivalent to the total antenna efficiency in the unfolding state or is improved by approximately 0.1 dB.

In embodiments of the present disclosure, a technique to provide antenna performance in a folding state of a foldable device at a level equivalent to antenna performance in an unfolding state or an improved level than antenna performance in an unfolding state has been described. In the folding state, in order to solve a physical factor that occurs as portions of a metal frame become adjacent, an additional radiator may be used. The radiation performance in the folding state may be improved by doubly feeding to a conductive portion used as an existing radiator and a conductive portion spaced apart from the conductive portion. The electronic device may adaptively change a feeding path in the folding state and the unfolding state through a switching circuit electrically connected to the two conductive portions. In the unfolding state, a signal may be fed to a single conductive portion. In the folding state, a bandwidth may be expanded and the total efficiency of the antenna may be increased, by a signal being fed to each of the two conductive portions including the single conductive portion in the folding state.

In embodiments, an electronic device 101 is provided. The electronic device 101 may comprise a processor 120 or 330, wireless communication circuitry 340, and 350 configured to provide a signal of a designated frequency band, a switching circuit 540, a first housing 210 including a first conductive portion 311, and a second housing 220 including a second conductive portion 312 and configured to be rotatable relative to the first housing 210. The processor 120 or 330 may be configured to, in an unfolding state in which a distance between the first conductive portion 311 and the second conductive portion 312 is longer than or equal to a certain distance, control the switching circuit 540 to transmit the signal through the second conductive portion 312. The processor 120 or 330 may be configured to, in a folding state in which the distance between the first conductive portion 311 and the second conductive portion 312 is shorter than the certain distance, control the switching circuit 540 to transmit the signal through each of the second conductive portion 312 and a third conductive portion 313, and 314. The second conductive portion 312 may be disposed to face at least a part of the first conductive portion 311 in the folding state. The third conductive portion 313, and 314 may be disposed at a position that is spaced apart from the second conductive portion 312 by a predefined distance or more in the folding state.

For example, the third conductive portion 313, and 314 may comprise a conductive portion, among a plurality of conductive portions of the electronic device 101, that is disposed at a position non-adjacent to both the first conductive portion 311 and the second conductive portion 312 in the folding state.

For example, at least a part of the third conductive portion 313, and 314 may be, among a plurality of conductive portions of the first housing 210, disposed at a position symmetrical to the second conductive portion 312. Or, at least a part of the third conductive portion 313, and 314 may be, among a plurality of conductive portions of the second housing 220, disposed at a position symmetrical to the second conductive portion 312.

For example, the processor 120 or 330 may be configured to provide a first signal to the switching circuit 540 in the unfolding state. The processor 120 or 330 may apply the first signal to the switching circuit 540 in the unfolding state. The processor 120 or 330 may be configured to provide a second signal to the switching circuit 540 in the folding state. The processor 120 or 330 may apply the second signal to the switching circuit 540 in the unfolding state. The switching circuit 540 may be configured to electrically connect the wireless communication circuitry 340, and 350 to the second conductive portion 312 based on the first signal. The switching circuit 540 may be configured to electrically connect the wireless communication circuitry 340, and 350 to each of the second conductive portion 312 and the third conductive portion 313, and 314 based on the second signal.

For example, the switching circuit 540 may include a first input port 541a for the signal of the wireless communication circuitry 340,and 350, a second input port 541b for ground, a first output port 541c for feeding power to the second conductive portion 312, and a second output port 541d for feeding power to both the second conductive portion 312 and the third conductive portion 313, and 314. The switching circuit 540 may be configured, based on the first signal, to connect the first input port 541a and the first output port 541c, and to connect the second input port 541b and the second output port 541d. The switching circuit 540 may be configured, based on the second signal, to connect the first input port 541a and the second output port 541d, and to connect the second input port 541b and the first output port 541c.

For example, the electronic device 101 may comprise a first printed circuit board (PCB) 301 disposed in the first housing 210. The electronic device 101 may comprise a second PCB 302 disposed in the second housing 220. The electronic device 101 may comprise a flexible radio frequency cable (FRC) 370 configured to connect the first PCB 301 and the second PCB 302.

For example, the third conductive portion 313 may be one of the plurality of conductive portions of the second housing 220. The third conductive portion 313 may be different from a conductive portion adjacent to the second conductive portion 312 among the plurality of conductive portions of the second housing 220.

For example, the processor 120 or 330 and the wireless communication circuitry 340, and 350 may be disposed on the first PCB 301. The switching circuit 540 may be disposed on the second PCB 302. A first feeding path for the second conductive portion 312 from the switching circuit 540 may be disposed on the second PCB 302. A second feeding path for both the second conductive portion 312 and the third conductive portion 313, and 314 from the switching circuit 540 may be disposed on the second PCB 302.

For example, the third conductive portion 314 may be one of the plurality of conductive portions of the first housing 210. The third conductive portion 314 may be different from a conductive portion adjacent to the first conductive portion 311 among the plurality of conductive portions of the first housing 210.

For example, the processor 120 and 330, the wireless communication circuitry 340 and 350, and the switching circuit 540 may be disposed on the first PCB 301. A first feeding path for the second conductive portion 312 from the switching circuit 540 may be formed across the first PCB 301, the FRC 370, and the second PCB 302. A second feeding path for both the second conductive portion 312 and the third conductive portion 313 and 314 from the switching circuit 540 may be distributed into a first feeding branch for the second conductive portion 312 and a second feeding branch for the third conductive portion 313 and 314. The first feeding branch for the second conductive portion 312 may be formed across the first PCB 301, the FRC 370, and the second PCB 302. The second feeding branch for the second conductive portion 312 may be disposed on the first PCB 301.

For example, the switching circuit 540 may comprise a double pole double throw (DPDT) switch. A first pole of the switching circuit 540 may be electrically connected to an output of the wireless communication circuitry 340 and 350. A second pole of the switching circuit 540 may be connected to ground. A first throw of the switching circuit 540 may be connected to a first feeding path for the second conductive portion 312. A second throw of the switching circuit 540 may be connected to a second feeding path for both the second conductive portion 312 and the third conductive portion 313 and 314.

For example, the electronic device 101 may comprise balun circuitry 850 electrically connected to the switching circuit 540. The balun circuitry 850 may be configured to provide a positive signal generated based on the signal, to one of the second conductive portion 312 and the third conductive portion 313 and 314. The balun circuitry 850 may be configured to provide a negative signal generated based on the signal, to another one among the second conductive portion 312 and the third conductive portion 313 and 314.

For example, the predefined distance may include a conductive portion adjacent to the second conductive portion 312, and a non-conductive portion between the second conductive portion 312 and the conductive portion.

For example, the wireless communication circuitry 340 and 350 may include a radio frequency integrated circuit (RFIC) 340 and a front end module (FEM) 350.

For example, the processor 120 and 330 may be configured to detect a state of the electronic device 101 through at least one sensor. The processor 120 and 330 may control at least one sensor to detect the state of the electronic device 101. The at least one sensor may include at least one of a hall sensor or a geomagnetic sensor. The state of the electronic device 101 may be the unfolding state or the folding state.

In embodiments, an electronic device 101 is provided. The electronic device 101 may comprise wireless communication circuitry 340 and 350 configured to provide a signal of a designated frequency band. The electronic device 101 may comprise a first housing 210 including a first conductive portion 311. The electronic device 101 may comprise a second housing 220 including a second conductive portion 312 and configured to be rotatable relative to the first housing 210. The wireless communication circuitry 340 and 350 may be configured to transmit the signal of the designated frequency band through only the second conductive portion 312 in an unfolding state. The wireless communication circuitry 340 and 350 may be configured to, in a folding state, transmit the signal of the designated frequency band through each of the second conductive portion 312 and the third conductive portion 313 and 314. In the folding state, a first display area of the first housing 210 and a second display area of the second housing 220 may face each other. In the unfolding state, the first display area and the second display area may face the same direction. The third conductive portion 313 and 314 may be different from a conductive portion adjacent to a first non-conductive portion for the first conductive portion 311 and a conductive portion adjacent to a non-conductive portion for the second conductive portion 312.

In embodiments, an electronic device 101 is provided. The electronic device 101 may comprise wireless communication circuitry 340 and 350 configured to provide a signal of a designated frequency band. The electronic device 101 may comprise a first housing 210 including a first conductive portion 311. The electronic device 101 may comprise a second housing 220 including a second conductive portion 312 and configured to be rotatable relative to the first housing 210. The wireless communication circuitry 340 and 350 may be configured to transmit the signal of the designated frequency band through the second conductive portion 312 without a third conductive portion 313 and 314 in an unfolding state. The wireless communication circuitry 340 and 350 may be configured to, in a folding state, transmit the signal of the designated frequency band through each of the second conductive portion 312 and the third conductive portion 313 and 314. In the folding state, a first display area of the first housing 210 and a second display area of the second housing 220 may face each other. In the unfolding state, the first display area and the second display area may face the same direction. The third conductive portion 313 and 314 may be different from a conductive portion adjacent to a first non-conductive portion for the first conductive portion 311 and a conductive portion adjacent to a non-conductive portion for the second conductive portion 312.

For example, the electronic device 101 may include a switching circuit 540. The switching circuit 540 may be configured to electrically connect the wireless communication circuitry 340 and 350 to the second conductive portion 312 without electrically connecting the wireless communication circuitry 340 and 350 to the third conductive portion 313 and 314 in the unfolding state. The switching circuit 540 may be configured to electrically connect the wireless communication circuitry 340, and 350 to the second conductive portion 312 and the third conductive portion 313 and 314 in the folding state.

For example, the electronic device 101 may comprise a first printed circuit board (PCB) 301 disposed in the first housing 210. The electronic device 101 may comprise a second PCB 302 disposed in the second housing 220. The processor 120 or 330 and the wireless communication circuitry 340, and 350 may be disposed on the first PCB 301. The switching circuit 540 may be disposed on the second PCB 302. The third conductive portion 313 may be one of a plurality of conductive portions of the second housing 220.

For example, the electronic device 101 may comprise the first printed circuit board (PCB) 301 disposed in the first housing 210. The electronic device 101 may comprise the second PCB 302 disposed in the second housing 220. The processor 120 or 330, the wireless communication circuitry 340, and 350, and the switching circuit 540 may be disposed on the first PCB 301. The third conductive portion 314 may be one of a plurality of conductive portions of the first housing 210.

For example, the switching circuit 540 may comprise a double pole double throw (DPDT) switch. The wireless communication circuitry 340 and 350 may include a radio frequency integrated circuit (RFIC) 340 and a front end module 350.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

Meanwhile, specific embodiments have been described in the detailed description of the present disclosure, and of course, various modifications are possible without departing from the scope of the present disclosure.

## Claims

1. An electronic device, comprising:
a processor;
wireless communication circuitry configured to provide a signal of a designated frequency band;
a switching circuit;
a first housing including a first conductive portion; and
a second housing including a second conductive portion and configured to be rotatable relative to the first housing,
wherein the processor is configured to:
in an unfolding state in which a distance between the first conductive portion and the second conductive portion is longer than or equal to a certain distance, control the switching circuit to transmit the signal through the second conductive portion; and
in a folding state in which the distance between the first conductive portion and the second conductive portion is shorter than the certain distance, control the switching circuit to transmit the signal through each of the second conductive portion and a third conductive portion,
wherein the second conductive portion is disposed to face at least part of the first conductive portion in the folding state, and
wherein the third conductive portion is disposed at a position that is spaced apart from the second conductive portion by a predefined distance or more in the folding state.

2. The electronic device of claim 1,
wherein the third conductive portion comprises a conductive portion, among a plurality of conductive portions of the electronic device, that is disposed at a position non-adjacent to both the first conductive portion and the second conductive portion in the folding state.

3. The electronic device of claim 1,
wherein at least part of the third conductive portion is:
among a plurality of conductive portions of the first housing, disposed at a position symmetrical to the second conductive portion; or
among a plurality of conductive portions of the second housing, disposed at a position symmetrical to the second conductive portion.

4. The electronic device of claim 1,
wherein the processor is configured to provide a first signal to the switching circuit in the unfolding state and a second signal to the switching circuit in the folding state, and
wherein the switching circuit is configured to:
connect the wireless communication circuitry to the second conductive portion electrically based on the first signal, and
connect the wireless communication circuitry to each of the second conductive portion and the third conductive portion electrically based on the second signal.

5. The electronic device of claim 4,
wherein the switching circuit includes:
a first input port (a) for the signal of the wireless communication circuitry,
a second input port (b) for ground,
a first output port (c) for feeding power to the second conductive portion, and
a second output port (d) for feeding power to both the second conductive portion and the third conductive portion,
wherein the switching circuit is configured, based on the first signal, to connect the first input port (a) and the first output port (c), and to connect the second input port (b) and the second output port (d), and
wherein the switching circuit is configured, based on the second signal, to connect the first input port (a) and the second output port (d), and to connect the second input port (b) and the first output port (c).

6. The electronic device of claim 3, further comprising:
a first printed circuit board (PCB) disposed in the first housing;
a second PCB disposed in the second housing; and
a flexible radio frequency cable (FRC) configured to connect the first PCB and the second PCB.

7. The electronic device of claim 6,
wherein the third conductive portion is one of the plurality of conductive portions of the second housing, and
wherein the third conductive portion is different from a conductive portion adjacent to the second conductive portion among the plurality of conductive portions of the second housing.

8. The electronic device of claim 7,
wherein the processor and the wireless communication circuitry are disposed on the first PCB,
wherein the switching circuit is disposed on the second PCB,
wherein a first feeding path for the second conductive portion from the switching circuit is disposed on the second PCB, and
wherein a second feeding path for both the second conductive portion and the third conductive portion from the switching circuit is disposed on the second PCB.

9. The electronic device of claim 6,
wherein the third conductive portion is one of the plurality of conductive portions of the first housing, and
wherein the third conductive portion is different from a conductive portion adjacent to the first conductive portion among the plurality of conductive portions of the first housing.

10. The electronic device of claim 9,
wherein the processor, the wireless communication circuitry, and the switching circuit are disposed on the first PCB,
wherein a first feeding path for the second conductive portion from the switching circuit is formed across the first PCB, the FRC, and the second PCB,
wherein a second feeding path for both the second conductive portion and the third conductive portion from the switching circuit is distributed into a first feeding branch for the second conductive portion and a second feeding branch for the third conductive portion,
wherein the first feeding branch for the second conductive portion is formed across the first PCB, the FRC, and the second PCB, and
wherein the second feeding branch for the second conductive portion is disposed on the first PCB.

11. The electronic device of claim 1,
wherein the switching circuit comprises a double pole double throw (DPDT) switch,
wherein a first pole of the switching circuit is electrically connected to an output of the wireless communication circuitry,
wherein a second pole of the switching circuit is connected to ground,
wherein a first throw of the switching circuit is connected to a first feeding path for the second conductive portion, and
wherein a second throw of the switching circuit is connected to a second feeding path for both the second conductive portion and the third conductive portion.

12. The electronic device of claim 1, further comprising:
balun circuitry electrically connected to the switching circuit,
wherein the balun circuitry is configured to provide a positive signal generated based on the signal, to one of the second conductive portion and the third conductive portion, and
wherein the balun circuitry is configured to provide a negative signal generated based on the signal, to another one among the second conductive portion and the third conductive portion.

13. The electronic device of claim 1,
wherein the predefined distance includes a conductive portion adjacent to the second conductive portion, and a non-conductive portion between the second conductive portion and the conductive portion.

14. The electronic device of claim 1, wherein the wireless communication circuitry includes a radio frequency integrated circuit (RFIC) and a front-end module (FEM).

15. The electronic device of claim 1,
wherein the processor is configured to control at least one sensor to detect a state of the electronic device,
wherein the at least one sensor includes at least one of a hall sensor or a geomagnetic sensor, and
wherein the state of the electronic device is the unfolding state or the folding state.
